# EUROPEAN PATENT SPECIFICATION

(11) **EP 2 537 780 B1**
(45) Date of publication and mention of the grant of the patent: **03.06.2020**
(21) Application number: 11744604.7
(22) Date of filing: 14.02.2011
(51) Int. Cl.: B65D 85/86, B65D 85/00, H01L 21/673, H01L 21/677

(54) **SUBSTRATE STORING CONTAINER**
SUBSTRATSPEICHERBEHÄLTER
CONTENANT DE STOCKAGE DE SUBSTRATS

(30) Priority: 19.02.2010 JP 2010035040
(43) Date of publication of application: 26.12.2012
(73) Proprietor: Shin-Etsu Polymer Co., Ltd., Chiyoda-ku Tokyo 101-0041 (JP)
(72) Inventor: FUJIMORI, Yoshiaki, Saitama-shi Saitama 331-0811 (JP); OGAWA, Osamu, Saitama-shi Saitama 331-0811 (JP)
(74) Representative: Osha Liang
(86) International application number: PCT/JP2011/053045
(87) International publication number: WO 2011/102318

(56) References cited:
- JP-A- 2004 193 381
- JP-A- 2004 515 065
- JP-A- 2005 353 898
- JP-A- 2006 120 851
- JP-A- 2008 040 810
- JP-A- 2008 040 810
- JP-A- 2008 141 130
- JP-A- 2008 270 281
- JP-A- 2009 111 057
- JP-A- 2009 206 258
- US-A1- 2002 038 773
- US-A1- 2005 109 669
- US-A1- 2010 028 111

## Description

### Technical Field

The present invention relates to a substrate storage container used for storage, preservation, transportation, shipment and other handling of substrates such as semiconductor wafers, glass wafers, glass masks and the like.

### Background Art

Though not illustrated, a conventional substrate storage container includes a container body for storage a plurality of semiconductor wafers in order and a door for opening and closing the open front of this container body, and is used for storage, preservation, transportation, shipment and other handling of semiconductor wafers, and mounted to a load port apparatus of processing equipment for semiconductor wafers (see patent documents 1, 2 3 and 4).

The container body and door are formed separately, and are basically and in most part molded of a molding material containing insulative resin that may be slightly electrified while part of them is formed of conductive materials. The container body has a fixing bottom plate and a plurality of positioning members for positioning, arranged on the bottom side in the bottom part thereof, and also has a plurality of pairs of left and right supporting pieces arranged vertically on both the interior sides thereof for horizontally retaining semiconductor wafers.

The plural positioning members fit on conductive positioning pins of the load port apparatus and function to position the container body or the substrate storage container with high precision. These plural positioning members and supporting pieces of the container body are all formed of conductive resin, and each positioning member and supporting piece are joined and connected by a conductive connecting member, so that this connecting member functions to release static charge on the semiconductor wafers supported by the supporting pieces to the outside to eliminate static electricity. Further, the backside wall of the container body is optionally formed with a view window for stored semiconductor wafers.

The door is formed in, for example, a rectangular shape, when viewed from the front, so as to correspond to the front of the container body, and is repeatedly fitted to, and taken out of, the open front of the container body. This door is formed on its front surface with insulative positioning indents to which conductive register pins of the load port apparatus fit, and also built in with a locking mechanism which can be externally operated. Further, in order to allow for observation of the locking mechanism, the door may be optionally given with optical transparency or made transparent, and is formed of a conductive resin in view of prevention of static charge arising on the parts of the locking mechanism.

### Prior Art Documents

### Patent Document

Patent Document 1: Japanese Patent Application Laid-open H11-513347
Patent Document 2: WO2009/089552
Patent Document 3: Japanese Patent Application Laid-open 2002-368074
Patent Document 4: US Patent Application US 2002/038773 A1

### Summary of the Invention

### Problems to be solved by the Invention

The substrate storage container in the prior art is configured as above. That is, other than the supporting pieces of the container body, the positioning members of the container body and the locking mechanism of the door, i.e., the interface portions with the load port apparatus as external equipment are partially formed of conductive materials, but it is impossible to form the whole of the container with conductive materials because it is necessary to form a view window in the container body and to form the door to be transparent to allow for observation of the locking mechanism.

For this reason, there is a risk of static charge arising thereon, attracting particles, causing semiconductor wafers to be stained. For example, when a view window is formed in the container body, there occur cases that static charge arises on the view window to attract particles, stain the rear part of semiconductor wafers. When the register pins of the load port apparatus fit to the positioning indents of the door, there occur cases that the positioning indents of the door are rubbed to be electrified, so that particles are attracted to the door, staining the front part of semiconductor wafers.

The present invention has been devised in view of the above, it is therefore an object of the present invention to provide a substrate storage container that can inhibit the container body, door and other parts from being electrified to attract particles, hence can prevent particles from staining substrates.

### Means for Solving the Problems

In order to solve the above problem, a substrate storage container of the present invention includes: a container body that stores substrates being supported by supporting pieces; a door that opens and closes an opening side of the container body; and an interface portion that is provided for the door to come in contact with external equipment, wherein when the door opens or closes the opening side of the container body, the door is intended to be connected to external equipment. The container body, supporting pieces thereof, the door and the interface portion are all formed of conductive materials so that the surface resistance values thereof fall within the range of 10³ to 10¹² Ω.

Here, a variation in surface resistance value of the container body, the supporting pieces thereof, the door and the interface portion falls within the range of 0 to 10⁶ Ω. Further, when the container body or the door is mounted to a charged plate monitor and applied with a voltage of 1000 V, the time in which the voltage attenuates from 1000 V to 100 V is equal to or shorter than 1 sec.

Preferably, the interface portion has a plurality of positioning indents that are provided on a surface of the door intended to be connected to corresponding register pins of a load port apparatus of the external equipment.

Preferably, the interface portion is further provided for at least one of: a bottom plate that is attached to the bottom of the container body and is intended to be in contact with a conveying system of the external equipment; positioning members that are provided on either the bottom of the container body or the bottom plate and intended to be connected to register pins of a load port apparatus of the external equipment; and a flange that is attached to the top of the container body and is intended to be in contact with the conveying system of the external equipment.

Further, the door includes: a casing that is fitted into the opening side of the container body; a front plate that covers the open front of this casing; a locking mechanism disposed between these casing and front plate; a retainer that is attached to the rear side of the casing to retain substrates at the rim; a sealing gasket that is fitted along the periphery of the casing and comes into contact with the inner periphery of the opening side of the container body; and door guides that are built in the casing and each have an inclined facet that passes through the peripheral wall of the casing to come into contact with the inner periphery of the opening side of the container body. Among the casing, front plate, at least part of the locking mechanism, retainer, sealing gasket and door guides, at least the casing can be formed of a conductive material.

In order to solve the above problem, a substrate storage container system of the present invention comprises the above-mentioned substrate storage container and an external equipment. The external equipment includes a load port apparatus for loading a substrate to or unloading a substrate to substrate processing equipment and a conveying system for conveying the container body to the load port apparatus. The load port apparatus includes a table for having the container body mounted thereon and a shutter that opens and closes a substrate input/output port and fitting the door to, and removing the door from, the container body, the table may have conductive positioning pins for the container body and the shutter may have conductive register pins for the door.

Further, it is preferable that the interface portion further contains, at least, one of a bottom plate that is attached to the bottom of the container body and can be in contact with the conveying system of the external equipment, positioning members that are provided on either the bottom of the container body or the bottom plate and positioned and connected by the register pins of the load port apparatus, and a flange that is attached to the top of the container body and can be in contact with the conveying system of the external equipment.

It is also preferable to prepare the conductive material by selectively adding carbon fiber, carbon black, carbon powder, carbon nanotubes, metal fiber, metal oxides and conductive polymers to the predetermined thermoplastic resin.

Here, the substrates defined in the scope of the claims may at least include a single or a plurality of semiconductor wafers, glass wafers, glass masks and the like of 200 mm, 300 mm and 450 mm in diameter. The container body may be given in any form of a front open box type, top open box type or bottom open box type. Further, the external equipment may at least include a load port apparatus, various types of overhead transport systems, conveyor systems and the like.

According to the present invention, since the conductive interface portion integrated with the container body or the door is put in contact with conductive pins of the external equipment so as to be electrically connected to each other forming a conduction path, it is possible to prevent the container body and the door from being electrified.

### Effect of the Invention

According to the present invention, since the container body, its supporting pieces, the door and the interface portion are all formed of conductive materials so that their surface resistance values are specified to fall within the range of 10³ to 10¹² Ω, this configuration is effective in inhibiting adherence of particles to the container body, the door and others to thereby prevent staining of substrates with particles.

### Brief Description of the Drawings

[FIG. 1] is an overall illustrative diagram schematically showing an embodiment of a substrate storage container according to the present invention.
[FIG. 2] is an exploded perspective diagram schematically showing an embodiment of a substrate storage container according to the present invention.
[FIG. 3] is a bottom-side illustrative diagram schematically showing an embodiment of a substrate storage container according to the present invention.
[FIG. 4] is a partial sectional illustrative diagram schematically showing the relationship between a door and a shutter of a load port apparatus in an embodiment of a substrate storage container according to the present invention.
[FIG. 5] is a front illustrative diagram schematically showing a door in the second embodiment of a substrate storage container of the present invention.
[FIG. 6] is a perspective illustrative diagram schematically showing a door guide in the second embodiment of a substrate storage container according to the present invention. Modes for Carrying Out the Invention

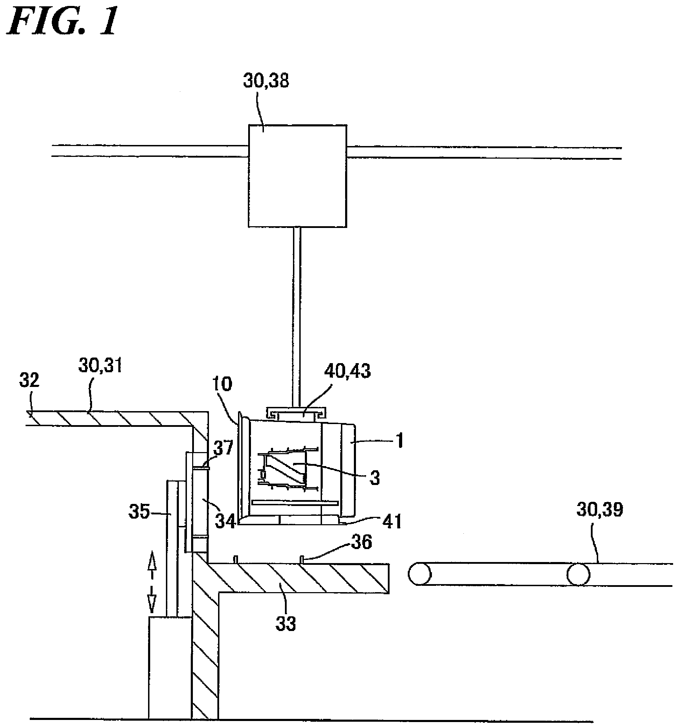

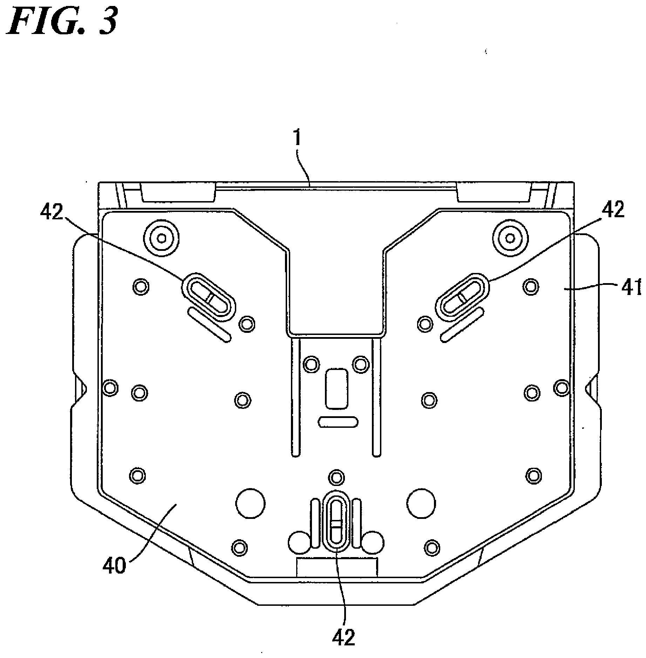

Now, an embodiment of the present invention will be described with reference to the drawings. As shown in FIGS. 1 to 4, a substrate storage container of the present embodiment includes: a container body 1 for storing and supporting semiconductor wafers W by plural supporting pieces 2; a removable door 10 that opens and closes the open front of this container body 1 and interface portions 40 that are arranged with the container body 1 and door 10 so as to be in contact with external equipment 30. Door 10 is positioned and connected to a load port apparatus 31 as external equipment 30 when door 10 opens or closes the open front of container body 1.

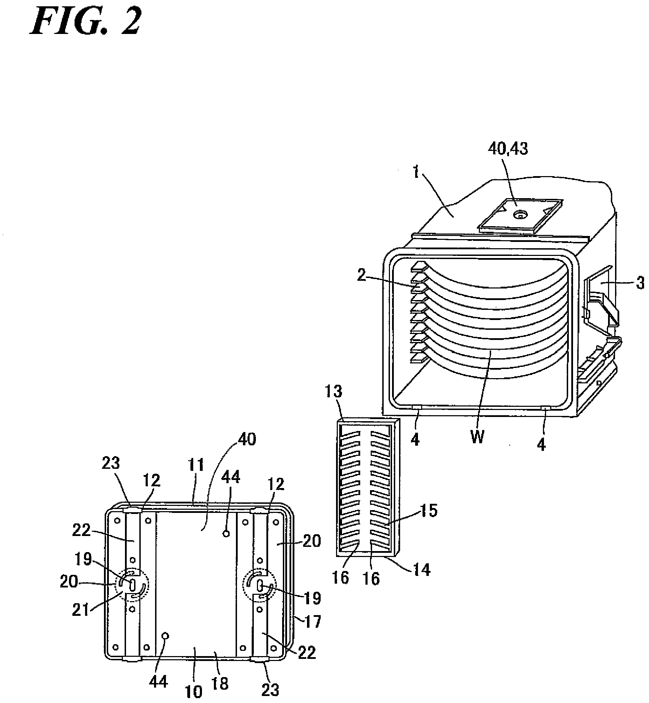

Semiconductor wafer W is a thin silicon wafer with a diameter of 300 mm, for example, and as shown in FIG. 2 a plurality of semiconductor wafers are put in order to container body 1, arranged from top to bottom and taken out by means of an unillustrated dedicated handling robot.

As shown in FIGS. 1 and 2, container body 1 is formed of a predetermined molding material into a front open box type having an open front. A pair of left and right supporting pieces 2 that horizontally support semiconductor wafer W are integrally formed in an opposing manner on both the interior sides or the side walls of the container body 1, a plurality of pairs of left and right supporting pieces 2 being vertically arranged with regular intervals. A pair of handles 3 for gripping operation are detachably attached on both exterior side walls of container body 1.

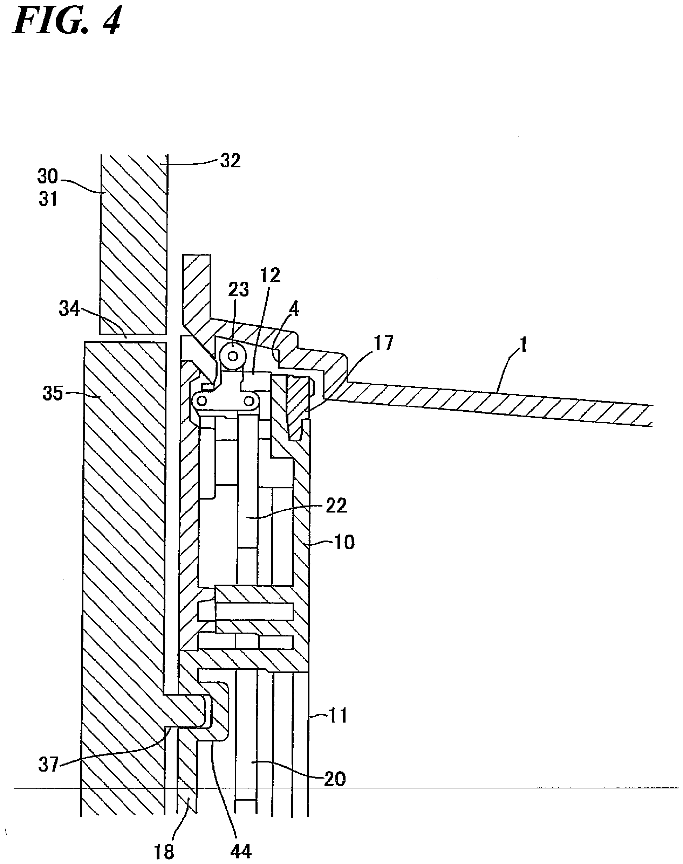

As shown in FIGS. 2 and 4, door 10 is composed of a laterally long casing 11 that is closely fitted into the open front of container body 1 in a sealed manner with a sealing gasket 17 in-between, a front plate 18 that covers the opening side (front) of this casing 11 and a locking mechanism 20 disposed between these casing 11 and front plate 18.

Casing 11 is given as an approximately dish-like form with a shallow bottom in section, basically having a frame-like peripheral wall while passage holes 12 for locking mechanism 20 are formed left and right in the top and bottom parts of the peripheral wall so that each passage hole 12 opposes an engagement hole 4 in the front inner periphery of container body 1. Attached to the rear side of casing 11 is a removable front retainer 13 that elastically holds the front rims of semiconductor wafers W.

Front retainer 13 has a vertically long frame14 that is removably attached in the center on the rear side of casing 11 to prevent deformation of door 10. Each of the left and right stiles of this frame 14 is integrally formed with rack pieces 15 that are arranged vertically, extending obliquely inward. Integrally formed at the front end of each rack piece 15 is a small holder block 16 for holding the front rim of semiconductor wafer W by means of a U-shaped groove or V-groove.

Formed along the periphery on the rear side of casing 11 is a frame-shaped fitting groove, to which sealing gasket 17 is closely fitted so as to create pressing contact with the inner periphery of the front of container body 1. This sealing gasket 17 is given in an elastically deformable frame-shaped molding, using, as a molding material, fluoro rubber, silicone rubber or thermoplastic elastomer (e.g., olefin-based, polyester-based, polystyrene-based, etc.) that is excellent in heat resistance and weather resistance and the like.

Front plate 18 is given in the form of a laterally long flat plate corresponding to the opening side of casing 11, and formed with pairs of operation holes 19 for locking mechanism 20, into which rotatable operational pins of load port apparatus 31 are inserted.

Locking mechanism 20 includes: a pair of rotary plates 21 that are disposed left and right and rotationally operated by operational pins of load port apparatus 31 that pass through operation holes 19 of front plate 18; a plurality of slide plates 22 that slide upwards and downwards as each rotary plate 21 rotates; and a plurality of engagement rollers 23 that are projected from passage holes 12 of casing 11 and engaged into engagement holes 4 of container body 1 as each slide plate 22 slides, and is positioned in front of front retainer 13.

As shown in FIG. 1, external equipment 30 is installed with the processing equipment of semiconductor wafers W, and includes: load port apparatus 31 that loads semiconductor wafer W to, and unloads semiconductor wafers from, the processing equipment; an overhead transport system 38 that is installed in the ceiling of the fabrication plant to transport the substrate storage container by hoisting to load port apparatus 31; and a conveyor system 39 made up of belt conveyors and the like that horizontally convey the substrate storage container to load port apparatus 31.

Load port apparatus 31 includes a table 33 that is formed with a partitioning wall 32 of the equipment to have container body 1 horizontally placed; and a shutter 35 that opens and closes input/output port 34 for semiconductor wafers W in partitioning wall 32 and moves up and down to fit door 10 to or remove it from, the front of container body 1. A plurality of positioning pins 36 are planted upright on the flat surface of table 33 while a plurality of register pins 37 for door 10 are attached horizontally to the surface of shutter 35. These multiple positioning pins 36 and register pins 37 are given in round-tipped cylindrical forms, using conductive material such as metal or the like.

Interface portions 40 include: as shown in FIGS. 1 to 4, a bottom plate 41 that is attached to the bottom side of the bottom part of container body 1 and can be arranged in contact with conveyor system 39; a plurality of positioning members 42 arranged on the bottom side in the bottom part of container body 1; a robotic flange 43 that is removably attached in the center of the top of container body 1 and is gripped by overhead transport system 38; a plurality of positioning indents 44 that are depressed on the front side of door 10 so as to receive register pins 37 of load port apparatus 31 and establish connection in position.

Bottom plate 41 is screw-fitted horizontally so as to cover the bottom side of container body 1 and is used for fixture and sensing of container body 1. The multiple positioning members 42 are each given in an approximately oval form when viewed in a plan and in an approximately V-shaped form when viewed in a section, and integrally formed at both side in the front part and at the center in the rear part on the bottom side of container body 1 so as to be exposed from bottom plate 41 and fit over positioning pins 36 of load port apparatus 31 to position container body 1 or the substrate storage container with high precision. On the other hand, multiple positioning indents 44 are arranged at positions, top and bottom, diagonally symmetrical to each other, on front plate 18 of door 10, each positioning indent 44 being given as a round hollow having a square bottom in section.

At this point, container body 1 and its supporting pieces 2, door 10 (especially, its casing 11 and front plate 18) and interface portions 40 are all formed of predetermined molding materials, specifically, having conductive materials whose surface resistance values fall within the range of 10³ to 10¹² Ω and provide functions of inhibiting particles from adhering due to electrification of static electricity, eliminating the risk of semiconductor wafers W being stained by adhering particles and preventing semiconductor wafers W from being charged with static electricity and dissipating static charge.

It is preferable to form container body 1 and its supporting pieces 2, door 10 and interface portions 40 of the same conductive material. However, if they are not the same, materials having close electrification ranks are selected. The variation in surface resistance value of container body 1 and its supporting pieces 2, door 10 and interface portions 40 is 0 to 10⁶ Ω, preferably 10³ Ω or below.

For example, the conductive material may be prepared by adding additives such as carbon fiber, carbon black, carbon powder, carbon nanotubes, metal fiber, metal oxides, conductive polymers and the like to a thermoplastic resin such as polycarbonate, polyetherimide, polyetheretherketone, liquid crystal polymer, cycloolefin polymer, polybutylene terephthalate, polyethylene naphthalate, etc. If the substrate storage container is demanded to be resistant to flame, the conductive material may be added with a flame retardant, or self-extinguishing polyetherimide, liquid crystal polymer or polyetheretherketone may be selected.

When polycarbonate, which is used as the main component of the material of container body 1 of the substrate storage container, is selected as the conductive material, 5 to 50 parts of carbon fiber by weight, preferably 10 to 30 parts by weight, are added to 100 parts of polycarbonate by weight. In this case, it is possible to set the surface resistance value of container body 1 within the range of 10³ to 10¹² Ω.

When carbon fiber is selected as the conductive material, it is preferably to use carbon fiber having a mean fiber length of 100 µm or less and a mean aspect ratio of 20 or lower. The conductive material prepared by mixing 1 to 10 parts of carbon black by weight with 1 to 10 parts of the above carbon fiber by weight, is the best for securing the dimensional accuracy and flatness of container body 1.

In this case, it is possible to obtain desired surface resistance even with a lower amount of carbon black added. Besides, compared to a case where carbonblackalone is blended, it is possible to enhance mechanical strength such as elasticity, and hence improve the degree of safety during storage and transportation. Here, use of carbon fiber having a mean aspect ratio of 20 or lower inhibits the orientation and makes it possible to form container body 1 with flatness and high dimensional precision.

Carbon fibers can be classified into pitch-derived carbon fibers made up of petroleum tar and pitch and PAN-derived carbon fibers made of acrylic long filaments, and either of them can be used. However, in view of purity and strength of carbon fibers, PAN-derived carbon fibers are preferably used.

Further, in order to improve the adhesive property and compatibility of carbon fiber with the thermoplastic resin, it is preferable to coat the surface of the carbon fiber with a thermoplastic resin or use a type of carbon fiber that has been surface-treated by oxidation. In particular, over-coating of carbon fiber bundles with the thermoplastic resin that is used for the substrate storage container, improves the adhesiveness with the thermoplastic resin and makes the fibers unlikely to release, hence making it possible to prevent staining of semiconductor wafers W.

When an incombustible liquid crystal polymer is selected as the material of container body 1, 5 to 50 parts of carbon fiber by weight are added to 100 parts of the resin by weight. Since liquid crystal polymers present large strength anisotropy depending on the orientation of polymers, it is possible to alleviate the anisotropy by adding 10 to 30 parts of glass fibers by weight. In this case, it is possible to set the surface resistance value of container body 1 within the range of 10³ to 10¹² Ω.

In the above, when semiconductor wafer W is loaded into the processing equipment of semiconductor wafer W, the substrate storage container is conveyed to table 33 of load port apparatus 31 by means of overhead transport system 38 and/or conveyor system 39 and positioned and mounted thereon. During this, overhead transport system 38 and conductive robotic flange 43 of container body 1 touch each other, or conveyor system 39 and conductive bottom plate 41 touch each other, and are electrically connected, forming an electric conduction path. As a result, it is possible to prevent container body 1 from being electrified, and in addition, release the static electricity charged on semiconductor wafer W to the outside.

Further, conductive positioning members 42 integrated with container body 1 and conductive positioning pins 36 of table 33 directly fit and contact with each other so as to position container body 1 while being electrically connected to form an electric condition path. As a result, it is possible to positively prevent electrification of container body 1 and in addition release the static electricity charged on semiconductor wafer W to the outside and dissipate the static charge.

When the container body 1 of the substrate storage container has been thus positioned and mounted on table 33 of load port apparatus 31, multiple register pins 37 projected from shutter 35 of load port apparatus 31 approach positioning indents 44 of door 10 and are positioned to fit into respective ones while shutter 35 is vacuum-suctioned to surface plate 18 of door 10 and the operational pins of shutter 35 pass through control ports 19 of door 10 to thereby unlock locking mechanism 20 that has been in a locked condition.

In this while, since positioning pins 36 of table 33 and positioning members 42 have been already electrically connected, it is possible to inhibit electrification of door 10 and adherence of particles even if conductive register pins 37 and conductive positioning indents 44 of door 10 repeatedly come in contact and rub with each other. Further, even if door 10 tends to be electrified, register pin 37 and positioning indent 44 directly touch each other to create electric connection, so that it is possible to eliminate electrification of door 10. In addition, when front retainer 13 is formed of a conductive material, static electricity charged on semiconductor wafer W can be released and dissipated to the outside via door 10.

Next, shutter 35 that has been vacuum-suctioned to door 10 moves downward so as to take door 10 from the front of container body 1 and open input/output port 34 of partitioning wall 32 to establish communication with the open front of container body 1, whereby semiconductor wafer W stored in container body 1 is loaded into the processing equipment by the dedicated handling robot.

According to the above configuration, since container body 1, door 10 and interface portions 40 are all formed of conductive materials so as to specify their surface resistance values within the range of 10<3>to 10<12> Ω, and the variation of these surface resistance values is specified to fall within the range of 0 to 10<6> Ω, it is possible to provide a substrate storage container that is hard to bear static charge and lessens adherence of particles to semiconductor wafers W, container body 1 and door 10.

Further, since other than container body 1 and door 10, interface portions 40 are also formed of conductive material, it is possible to easily dissipate static electricity charged on the substrate storage container to the ground when the substrate storage container makes access to load port apparatus 31, overhead transport system 38 and/or conveyor system 39 as external equipment 30.

Here, particles are not particularly limited, but it is preferable that increase in number of particles adhering on semiconductor wafer W is equal to or lower than 10, from the number of particles on semiconductor wafer W measured before storage into container body 1 under a clean room environment by means of a wafer surface inspector or the like, when the semiconductor wafer W has been stored into container body 1 with the open front fitted with door 10 and locked, and 600 times of opening and closing of door 10 have been repeated.

Also, attenuation time as to electrified container body 1 and door 10 is not particularly limited, but it is preferable that when container body 1 or door 10 is mounted on a charged plate monitor and applied with a voltage of 1000 V and the time in which the voltage attenuates from 1000 V to 100 V or preferably to 50 V is 1 sec or shorter. These surface resistance values, particles on semiconductor wafer W and attenuation time are preferably measured at a temperature of 23 deg.C with a relative humidity of 50 to 60 % under a clean room environment class 100, based on USA Federal Specifications and Standards FED-STD-209D.

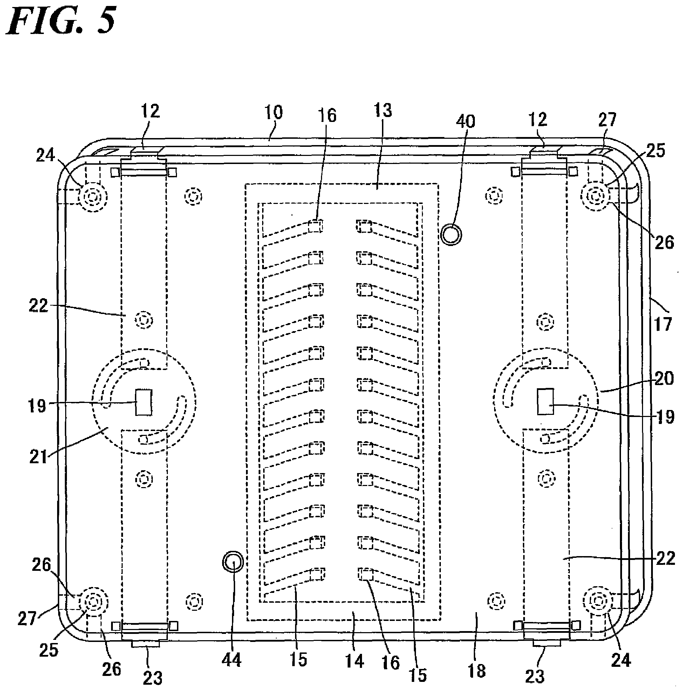

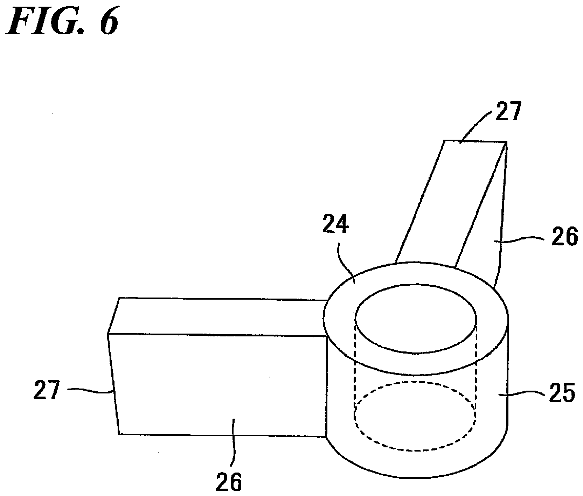

Next, FIGS. 5 and 6 show the second embodiment of the present invention. In this case, a positioning door guide 24 relative to container body 1 is built in at each of the four corners of door 10 while these multiple door guides 24, front retainer 13, sealing gasket 17 and at least slide plates 22 and engagement rollers 23 of locking mechanism 20 are formed of conductive material.

Each door guide 24 includes a cylindrical attachment 25 to be fit at the inner corner of casing 11 of door 10. A pair of arms 26 forming the letter L, is formed with a predetermined angle on the outer peripheral side of this attachment 25. Each arm 26 is formed at its distal end with an inclined facet 27 that passes through the peripheral wall of casing 11 and comes in contact with the inner periphery of the front of container body 1. Other components are approximately the same as the above-described embodiment so that description is omitted.

Also in this embodiment, it is possible to expect the same operation and effect as in the above embodiment. Besides, it is apparent that it is possible to create an electric conduction path between container body 1 and door 10 and release and dissipate static electricity charged on semiconductor wafers W to the outside through both container body 1 and door 10.

The backside wall of container body 1 in the above embodiment may be coated with a conductive polymer such as polypyrrole, polythiophene and the like, or may be formed with a view window made of transparent conductive polycarbonates by insert molding using an alloy method and the like. Further, separate stiles may be vertically arranged in the center between the top and bottom horizontal crosspieces of frame 14 forming front retainer 13 and the ends of multiple rack pieces 15 are connected to the vertical stile while a holder block 16 may be integrally formed with each rack piece 15. Further, locking mechanism 20 may be all formed of conductive material.

Next, examples of the present invention will be described together with a comparative example.

### [Example 1]

The container body and its multiple supporting pieces and door of the substrate storage container shown in FIG. 2 as well as the interface portions were all formed of predetermined molding materials, that is, conductive materials, and the surface resistance values, attenuation time, the number of particles after PWP test and the like were measured and the result is shown in Table 1.

Assumed as the interface portions were multiple positioning members and robotic flange of the container body and the positioning indents of the door. The conductive material was prepared by blending 100 parts of polycarbonate by weight with 10 parts of carbon fiber by weight.

### [Example 2]

This example is basically the same as example 1, except that the conductive material was changed and prepared by blending 100 parts of liquid crystal polymer by weight with 15 parts of carbon fiber by weight.

### [Example 3]

This example is basically the same as example 1, except that the casing of the door alone was formed with a conductive material while the front plate of the door was formed of a non-conductive transparent polycarbonate and coated with a polypyrrole liquid. The conductive material was prepared by blending 100 parts of liquid crystal polymer by weight with 10 parts of carbon fiber by weight.

### [Comparative Example]

The container body having multiple supporting pieces shown in FIG. 2 and the interface portions are all formed of predetermined materials, that is, conductive materials, and the surface resistance values, attenuation time, the number of particles after PWP test and the like were measured and the result is shown in Table 1.

Assumed as the interface portions were multiple positioning members and robotic flange of the container body. The conductive material was prepared by blending 100 parts of polycarbonate by weight with 10 to 20 parts of carbon fiber by weight.

### [Measurement of Surface Resistance Value]

A resistance measuring device (Model 5501DM, a product of SANWA M. I. TECHNOS CO., LTD) was used to measure the surface resistance value of the substrate storage container under an environment with a temperature of 24 deg. C and a relative humidity of 50 %, based on ASTM D257.

In measuring the surface resistance value of the container body, measurement was carried out by pressing the electrodes against and between the supporting piece of the container body and the positioning member of the interface portion. Further, in measuring the surface resistance value of the door, measurement was carried out by pressing the electrodes against and between the casing of the door and the positioning indent of the interface portion.

### [Measurement of Attenuation Time]

First, under an environment with a temperature of 24 deg.C and a relative humidity of 50 %, the container body was mounted on a charged plate monitor (CPM210, a product of HARADA COOPERATION) with the electrodes pressed against and between the supporting piece and the positioning member of the interface portion to apply a voltage of 1000 V, then the time in which the voltage attenuated from 1000 V to 100 V was measured.

Subsequently, in the same environment, the door was mounted on a charged plate monitor (CPM210, a product of HARADA COOPERATION) with the electrodes pressed against and between the casing and the positioning indent of the interface portion to apply a voltage of 1000 V, then the time in which the voltage attenuated from 1000 V to 100 V was measured.

### [Measurement of the Number of Particles after PWP Test]

The numbers of particles on 300-mm diameter silicon wafers stored in the substrate storage container of the examples and in the substrate storage container of the comparative example, were measured by a well-known wafer surface inspector, and the semiconductor wafers were stored into the substrate storage containers of examples 1, 2 and 3 and into the substrate storage container of the comparative example, and locked, and then 600 times of opening and closing of the door were repeated by a load port apparatus (a product of TDK Corporation) for door opening and closing.

After 600 times of opening and closing the door were repeated, the number of particles adhering on the silicon wafer was measured once again by the wafer surface inspector so as to confirm the number of increase in number of particles adhering to the silicon wafer. The size of particles measured by the wafer surface inspector was from 0.1 to 5.125 µm.

**[Table 1]**

| | Example 1 | Example 2 | Example 3 | Comparative Example |
|---|---|---|---|---|
| Surface Resistance (Ω) between Container Body and its Interface Portion | 4 × 10⁶ | 4 × 10⁴ | 2 × 10⁶ | 5 × 10⁶ |
| Surface Resistance (Ω) between Door and its Interface Portion | 5 × 10⁶ | 2 × 10³ | 5 × 10¹² | 3 × 10¹⁴ |
| Attenuation Time (sec) between Container Body and Interface Portion | 0.1 | 0.1 | 0.1 | 0.1 |
| Attenuation Time (sec) between Door and its Interface Portion | 0.1 | 0.1 | 0.2 | Infinite |
| Increase in number of particles after PWP test | 5 | 4 | 8 | 17 |

As apparent from Table 1, the substrate storage containers of examples 1, 2 and 3 can present finely beneficent result as to surface resistance value, attenuation time, the number of particles after PWP test and the like.

### Industrial Applicability

The substrate storage container according to the present invention can be used in the manufacturing field of semiconductors, liquid crystal and the like.

### Description of Reference Numerals

1 container body
2 supporting piece
10 door
11 casing
18 front plate
20 locking mechanism
30 external equipment
31 load port apparatus (external equipment) 33 table
34 input/output port
35 shutter
36 positioning pin
37 register pin
38 overhead transport system (external equipment, transport system)
39 conveyor system (external equipment, transport system)
40 interface portion
41 bottom plate
42 positioning member
43 robotic flange (flange)
44 positioning indent
W semiconductor wafer (substrate)

## Claims

1. A substrate storage container comprising: a container body (1) that stores substrates being supported by supporting pieces (2) ; a door (10) that opens and closes an opening side of the container body (1) ; and an interface portion (40) that is provided for the door (10) to come in contact with external equipment (30), wherein when the door (10) opens or closes the opening side of the container body (1), the door (10) is intended to be connected to external equipment (30),
wherein the container body (1), supporting pieces (2) thereof, the door (10) and the interface portion (40) are all formed of conductive materials so that the surface resistance values thereof fall within the range of 10³ to 10¹² Ω, and wherein a variation in surface resistance values among the container body (1), the supporting pieces (2), the door (10) and the interface portion (40) falls within the range of 0 to 10⁶ Ω,
wherein the container body (1) or the door (10) is configured to be mountable to a charged plate monitor,
and wherein when the container body (1) or the door (10) is mounted to the charged plate monitor and applied with a voltage of 1000 V, the time in which the voltage attenuates from 1000 V to 100 V is equal to or shorter than 1 sec.

2. The substrate storage container according to claim 1, wherein the interface portion (40) has a plurality of positioning indents (44) that are provided on a surface of the door (10) intended to be connected to corresponding register pins (37) of a load port apparatus (31) of the external equipment (30).

3. The substrate storage container according to claim 1, wherein the interface portion (40) is further provided for at least one of:
a bottom plate (41) that is attached to the bottom of the container body (1) and is intended to be in contact with a conveying system of the external equipment (30);
positioning members (42) that are provided on either the bottom of the container body (1) or the bottom plate (41) and intended to be connected to register pins (37) of a load port apparatus (31) of the external equipment (30); and
a flange that is attached to the top of the container body (1) and is intended to be in contact with the conveying system of the external equipment (30).

4. A substrate storage system comprising the substrate storage container according to any one of claims 1 to 2 and an external equipment (30), wherein the external equipment (30) includes a load port apparatus (31) for loading a substrate to or unloading a substrate to substrate processing equipment and a conveying system for conveying the container body (1) to the load port apparatus (31), and
the load port apparatus (31) includes a table (33) for having the container body (1) mounted thereon and a shutter (35) that opens and closes a substrate input/output port (34) and fitting the door (10) to, and removing the door (10) from, the container body (1), the table (33) having conductive positioning pins (36) for the container body (1) and the shutter (35) having conductive register pins (37) for the door (10) .

5. The substrate storage system according to claim 4, wherein the interface portion (40) further contains, at least, one of a bottom plate (41) that is attached to the bottom of the container body (1) and can be in contact with the conveying system of the external equipment (30); positioning members (42) that are provided on either the bottom of the container body (1) or the bottom plate (41) and positioned and connected by the register pins (37) of the load port apparatus (31); and a flange that is attached to the top of the container body (1) and can be in contact with the conveying system of the external equipment (30).

## Patentansprüche

1. Substrataufbewahrungsbehälter umfassend: einen Behälterkörper (1) zur Aufbewahrung von Substraten, die von Halterungselementen (2) gehaltert sind; eine Tür (10) zum Öffnen und Schließen einer Öffnungsseite des Aufbewahrungsbehälters (1); und einen Verbindungsabschnitt (40), der dazu dient, die Tür (10) mit externem Equipment (30) in Kontakt zu bringen, wobei die Tür (10) die Öffnungsseite des Behälterkörpers (1) öffnet und schließt und die Tür (10) dazu vorgesehen ist, mit dem externen Equipment (30) verbunden zu werden,
wobei der Behälterkörper (1), dessen Halterungselemente (2), die Tür (10) und der Verbindungsabschnitt (40) jeweils aus leitendem Material bestehen, so dass die Oberflächenwiderstandswerte in einem Bereich von 10³ bis 10¹² Ω liegen, und wobei eine Änderung der Oberflächenwiderstandwerte des Behälterkörpers (1), der Halterungselemente (2), der Tür (10) und des Verbindungsabschnitts (40) in einen Bereich von 0 - 10⁶ Ω fällt,
wobei der Behälterkörper (1) oder die Tür (10) an einem geladenen Plattenmonitor anbringbar ist, und
wobei, wenn der Behälterkörper (1) oder die Tür (10) an dem geladenen Plattenmonitor angebracht ist und eine Spannung von 1000V an diesen angelegt wird, die Zeitspanne, innerhalb derer die Spannung von 1000V auf 100 V abnimmt, 1 Sekunde oder weniger beträgt.

2. Substrataufbewahrungsbehälter gemäß Anspruch 1, wobei der Verbindungsabschnitt (40) eine Mehrzahl von in einer Oberfläche der Tür (10) vorgesehenen Positionierausnehmungen (44) aufweist, die mit entsprechenden Passstiften (37) eines Ladeanschlusses (31) des externen Equipments (30) in Verbindung bringbar sind.

3. Substrataufbewahrungsbehälter gemäß Anspruch 1, wobei der Verbindungsabschnitt (40) des Weiteren für wenigstens eine der folgenden Komponenten bereitgestellt ist:
eine Bodenplatte (41), die an dem Boden des Behälterkörpers (1) befestigt und mit einem Fördersystem des externen Equipments (30) verbindbar ist;
Positionierelemente (42), die entweder am Boden des Behälterkörpers (1) oder der Bodenplatte (41) vorgesehen sind und mit den Passstiften (37) eines Ladeanschlusses (31) des externen Equipments (30) verbindbar ist; und
einen Flansch, der an der Oberseite des Behälterkörpers (1) befestigt ist und mit dem Fördersystem des externen Equipments (30) kontaktierbar ist.

4. Substrataufbewahrungssystem umfassend den Substrataufbewahrungsbehälter gemäß einem der Ansprüche 1 bis 2 und ein externes Equipment (30), wobei das externe Equipment (30) einen Ladeanschluss (31) zum Laden eines Substrats oder zum Entladen eines Substrats zu einem Substratverarbeitungsequipment und ein Fördersystem zum Befördern des Behälterkörpers (1) zu dem Ladeanschluss (31) aufweist, und der Ladeanschluss (31) einen Tisch (33) zur Befestigung des Behälterkörpers (1) darauf aufweist sowie eine Schließvorrichtung (35) zum Öffnen und Schließen einer Substrat-Eingangs/Ausgangs-Öffnung (34) und zur Anbringung der Tür (10) an und zur Entfernung der Tür von dem Behälterkörper (10), wobei der Tisch (33) leitende Positionierstifte (34) für den Behälterkörper (1) aufweist und die Schließvorrichtung (35) leitende Passstifte (37) für die Tür (10) aufweist.

5. Substrataufbewahrungssystem gemäß Anspruch 4, wobei der Verbindungsabschnitt (40) des Weiteren aufweist:
eine Bodenplatte (41), die am Boden des Behälterkörpers (1) befestigt und mit dem Fördersystem des externen Equipments (30) kontaktierbar ist; und/oder Positionselemente (42), die entweder am Boden des Behälterkörpers (1) oder der Bodenplatte (41) vorgesehen sind und mittels der Passstifte (37) des Ladeanschlusses (31) positioniert und verbunden sind; und/oder
einen Flansch, der an der Oberseite des Behälterkörpers (1) befestigt und mit dem Fördersystem des externen Equipments (30) kontaktierbar ist.

## Revendications

1. Conteneur de stockage de substrats comprenant : un corps de conteneur (1) qui stocke des substrats supportés par des pièces de support (2) ; une porte (10) qui ouvre et ferme un côté d'ouverture du corps de conteneur (1) ; et une partie d'interface (40) qui est prévue pour que la porte (10) vienne en contact avec un équipement externe (30), dans lequel lorsque la porte (10) ouvre ou ferme le côté d'ouverture du corps de conteneur (1), la porte (10) est destinée à être connectée à un équipement externe (30),
dans lequel le corps du conteneur (1), ses pièces de support (2), la porte (10) et la partie d'interface (40) sont tous formés de matériaux conducteurs de sorte que leurs valeurs de résistance de surface se situent dans la plage de 10³ à 10¹² Ω, et dans lequel une variation des valeurs de résistance de surface entre le corps du conteneur (1), les pièces de support (2), la porte (10) et la partie d'interface (40) se situe dans la plage de 0 à 10⁶ Ω
dans lequel le corps du conteneur (1) ou la porte (10) est configuré pour pouvoir être monté sur un moniteur à plaque chargée, et
dans lequel, lorsque le corps du conteneur (1) ou la porte (10) est monté sur le moniteur de plaque chargée et qu'une tension de 1000 V lui est appliquée, le temps pendant lequel la tension s'atténue de 1000 V à 100 V est égal ou inférieur à 1 seconde.

2. Le conteneur de stockage de substrat selon la revendication 1, dans lequel la partie d'interface (40) a une pluralité d'indentations de positionnement (44) qui sont prévues sur une surface de la porte (10) destinée à être connectée à des broches de repérage correspondantes (37) d'un appareil à orifice de chargement (31) de l'équipement externe (30) .

3. Conteneur de stockage de substrat selon la revendication 1, dans lequel la partie d'interface (40) est en outre prévue pour au moins un des éléments suivants :
une plaque de fond (41) qui est fixée au fond du corps du conteneur (1) et qui est destinée à être en contact avec un système de transport de l'équipement externe (30) ;
des éléments de positionnement (42) qui sont prévus soit sur le fond du corps du conteneur (1) ou sur la plaque de fond (41) et destinés à être reliés aux broches de repérage (37) d'un appareil à orifice de chargement (31) de l'équipement externe (30) ; et
une bride qui est fixée au sommet du corps du conteneur (1) et qui est destinée à être en contact avec le système de transport de l'équipement externe (30).

4. Un système de stockage de substrat comprenant le conteneur de stockage de substrat selon l'une quelconque des revendications 1 à 2 et un équipement externe (30), dans lequel l'équipement externe (30) comprend un appareil à orifice de chargement (31) pour charger un substrat sur ou décharger un substrat sur un équipement de traitement de substrat et un système de transport pour transporter le corps du conteneur (1) vers l'appareil à orifice de chargement (31), et
l'appareil à orifice de chargement (31) comprend une table (33) sur laquelle est monté le corps du conteneur (1) et un obturateur (35) qui ouvre et ferme un orifice d'entrée/sortie de substrat (34) et qui fixe la porte (10) au corps du conteneur (1) et enlève la porte (10) de celui-ci, la table (33) ayant des broches de positionnement conductrices (36) pour le corps du conteneur (1) et l'obturateur (35) ayant des broches de repérage conductrices (37) pour la porte (10).

5. Système de stockage de substrat selon la revendication 4, dans lequel la partie d'interface (40) contient en outre, au moins, une plaque de fond (41) qui est fixée au fond du corps du récipient (1) et peut être en contact avec le système de transport de l'équipement externe (30) ; des éléments de positionnement (42) qui sont prévus soit sur le fond du corps du conteneur (1) soit sur la plaque de fond (41) et qui sont positionnés et reliés par les broches de repérage (37) de l'appareil à orifice de chargement (31) ; et une bride qui est fixée au sommet du corps du conteneur (1) et qui peut être en contact avec le système de transport de l'équipement externe (30).
